# EUROPÄISCHE PATENTSCHRIFT

(11) **EP 2 148 367 B1**
(45) Veröffentlichungstag und Bekanntmachung des Hinweises auf die Patenterteilung: **23.03.2011**
(21) Anmeldenummer: 09008701.6
(22) Anmeldetag: 03.07.2009
(51) Int. Cl.: H01L 25/07, H01L 23/367

(54) **Leistungshalbleitermodul**
Semiconductor power module
Module semi-conducteur de puissance

(30) Priorität: 24.07.2008 DE 102008034468
(43) Veröffentlichungstag der Anmeldung: 27.01.2010
(73) Patentinhaber: Semikron Elektronik GmbH & Co. KG Patentabteilung, 90431 Nürnberg (DE)
(72) Erfinder: Knebel, Markus, 90587 Tuchenbach (DE)

(56) Entgegenhaltungen:
- EP-A- 0 352 429
- WO-A-2006/053846
- WO-A-2006/063539
- DE-A1-102006 013 078
- DE-B3-102006 027 482

## Beschreibung

Die Erfindung beschreibt ein gehaustes Leistungshalbleitermodul mit einem ersten, als alternierende Schichtfolge ausgestalteten Kontaktelement zur elektrischen Verbindung der Last- und Steueranschlüsse von Leistungshalbleiterbauelementen und mit einem zweiten Kontaktelement zur externen Kontaktierung.

Einen Ausgangspunkt der Erfindung bilden Leistungshalbleitermodule, wie sie beispielhaft aus der DE 103 55 925 A1 und aus der DE 10 2006013078 A1 bekannt sind. Die erstgenannte Druckschrift offenbart ein Kontaktelement für Leistungshalbleiterbauelemente bestehend aus einem Folienverbund einer ersten und einer zweiten leitenden Folie mit einer isolierenden Zwischenlage. Die Leistungshalbleiterbauelemente sind mit der ersten leitenden Schicht mittels Ultraschallschweißen dauerhaft sicher elektrisch verbunden. Die modulinterne schaltungsgerechte Verbindung der Leistungshalbleiterbauelemente, die sowohl Last- als auch Steueranschlüsse beinhaltet, ist hier offengelegt. Allerdings offenbart die genannte Druckschrift keine Details der Last- und Steuerverbindungen zur externen Anbindung.

Die DE 10 2006013078A1 offenbart ein Leistungshalbleitermodul mit einem Gehäuse, einem Substrat und dem aus der DE 103 55 925 A1 bekannten Kontaktelement als Folienverbund, wobei der Folienverbund in einzelnen definierten Abschnitten durch Führungsabschnitte im Gehäuse an die Außenseite des Gehäuses reicht, um dort Last- und Steueranschlüsse mit einer externen Leiterplatte zu gewährleisten.

Nachteilig ist hierbei, dass die Kontaktierung zur externen Leiterplatte mittels einer Lotverbindung ausgestaltet ist, die bei einem Entlöten und erneutem Löten der Kontaktierung aufgrund der hohen Flexibilität des ersten Kontaktelements erneut angebracht und entsprechend der Schaltungstopologie der externen Leiterplatte mit den Kontaktflächen erneut ausgerichtet werden muss. Näheres zum Stand der Technik offenbart DE 10 2006 027 482 B3, die eine gehauste Halbleiterschaltungsanordnung mit einem Substrat mit Leiterbahnen und hierauf schaltungsgerecht angeordneten Halbleiterbauelementen und mit einer Verbindungseinrichtung beschreibt. Die Verbindungseinrichtung besteht aus einer Folienverbindung mit mindestens zwei leitenden Schichten, eine davon weist eine interne Kontaktiereinrichtung auf. Für eine Verbindung mit externen Zuleitungen liegt ein Federelement mit einem Widerlager im Gehäuse oder eine Feststellschraube vor.

Der Erfindung liegt die Aufgabe zugrunde, ein Leistungshalbleitermodul mit einem Gehäuse und einem als alternierende Schichtfolge ausgestalteten ersten Kontaktelement und einem zweiten Kontaktelement zur externen Kontaktierung vorzustellen, wobei das Leistungshalbleitermodul einfach herzustellen ist und eine zuverlässige Kontaktierung des ersten Kontaktelements mit dem zweiten Kontaktelement des Leistungshalbleitermoduls erlaubt.

Die Erfindung sieht ein Leistungshalbleitermodul gemäß Anspruch 1 vor. Bevorzugte Ausführungsformen der Erfindung sind in den Unteransprüchen beschrieben.

Die beanspruchte Erfindung lässt sich durch die in dieser Schrift, d.h. in der vorliegenden Beschreibung sowie in den Zeichnungen, beschriebenen und dargestellten Ausführungsbeispiele besser verstehen. Im Allgemeinen spiegelt die vorliegende Offenbarung bevorzugte Ausführungsbeispiele der Erfindung. Dem aufmerksamen Leser wird jedoch auffallen, dass einige Aspekte der beschriebenen Ausführungsbeispiele über den Schutzumfang der Ansprüche hinausragen. Sofern die beschriebenen Ausführungsbeispiele tatsächlich über den Schutzumfang der Ansprüche hinausragen, sind die beschriebenen Ausführungsbeispiele als zusätzliches Hintergrundinformation zu betrachten und stellen keine Definition der Erfindung per se dar.

Der erfinderische Gedanke geht aus von einem Leistungshalbleitermodul mit einem Gehäuse, mindestens einem Substrat mit ersten Leiterbahnen und auf diesen Leiterbahnen schaltungsgerecht angeordneten Leistungshalbleiterbauelementen.

Weiterhin weist das Leistungshalbleitermodul mindestens ein erstes Kontaktelement auf, wobei dieses aus einer alternierenden Schichtfolge aus mindestens einer leitenden Schicht und mindestens einer isolierenden Schicht besteht. Die mindestens eine leitende Schicht ist in sich strukturiert und bildet somit zweite Leiterbahnen aus, welche die Last- und Steueranschlussflächen der Leistungshalbleiterbauelemente schaltungsgerecht kontaktieren. Ein erster Kontaktabschnitt des ersten Kontaktelements wird mittels einem im Gehäuse angeordneten und dem ersten Kontaktelement entsprechend zugeordneten Widerlager im Inneren des Leistungshalbleitermoduls adjustiert und gelagert. Hierbei kann es bevorzugt sein, das Widerlager einstückig aus dem Gehäusematerial auszubilden. Weiterhin ist es zur Adjustierung und Lagerung des ersten Kontaktelements vorteilhaft, wenn das Widerlager mit einer Seitenfläche des Gehäuses einen Winkel einschließt.

Weiterhin weist das Leistungshalbleitermodul mindesten ein zweites Kontaktelement auf, welches bevorzugt fest mit dem Gehäuse verbunden ist und durch jeweils eine angeordnete Durchführung im Gehäuse an dessen Außenseite reicht und dort zur externen Kontaktierung beispielsweise mit einer externen Leiterplatte dient. Hierbei bildet das zweite Kontaktelement einen zweiten Kontaktabschnitt im Inneren des Leistungshalbleitermoduls aus, welcher durch eine erfindungsgemäße elektrisch leitende Verbindung mit dem ersten Kontaktabschnitt des ersten Kontaktelements eine schaltungsgerechte Kontaktierung im Sinne einer elektrisch leitenden Verbindung zwischen den Leistungshalbleiterbauelementen und einer externen Kontaktierung ermöglicht. Hierzu bildet das zweite Kontaktelement einen dritten Kontaktabschnitt aus, welcher durch die ihm jeweils zugeordnete Durchführung im Gehäuse an dessen Außenseite reicht.

Hierbei bildet sich erfindungsgemäß zwischen dem ersten Kontaktelement an dem ihm zugeordneten Widerlager und dem zweiten Kontaktelement an dessen Führungsabschnitt ein Zwischenraum aus, in welchen ein elektrisch leitender Füllstoff, vorzugsweise ein Lot, eingebracht wird. Der entstehende Zwischenraum ist hierbei durch die Anordnung des Widerlagers vorzugsweise keilförmig ausgestaltet, kann jedoch ebenso annähernd trichterförmig ausgestaltet sein. Bei der Ausbildung des Zwischenraum ist es erfindungsgemäß vorteilhaft, dass das erste, als alternierende Schichtfolge ausgestaltete und daher flexible Kontaktelement sicher gelagert wird und sich gleichzeitig eine zuverlässige elektrisch leitende Verbindung zum zweiten Kontaktelement ausbildet.

Die erfinderische Lösung wird an Hand der Fig. 1 bis 3 weiter erläutert.

Fig. 1 zeigt ein Leistungshalbleitermodul mit einer angeordneten externen Leiterplatte gemäß dem Stand der Technik im Querschnitt sowie eine vergrößerte Ansicht eines Bereiches im Querschnitt.

Fig. 2 zeigt in einem Ausschnitt eine Ausgestaltung eines erfindungsgemäßen Leistungshalbleitermoduls mit einer angeordneten externen Leiterplatte im Querschnitt.

Fig. 3 zeigt einen Ausschnitt eines erfindungsgemäßen Leistungshalbleitermoduls in dreidimensionaler Seiten-Draufsicht.

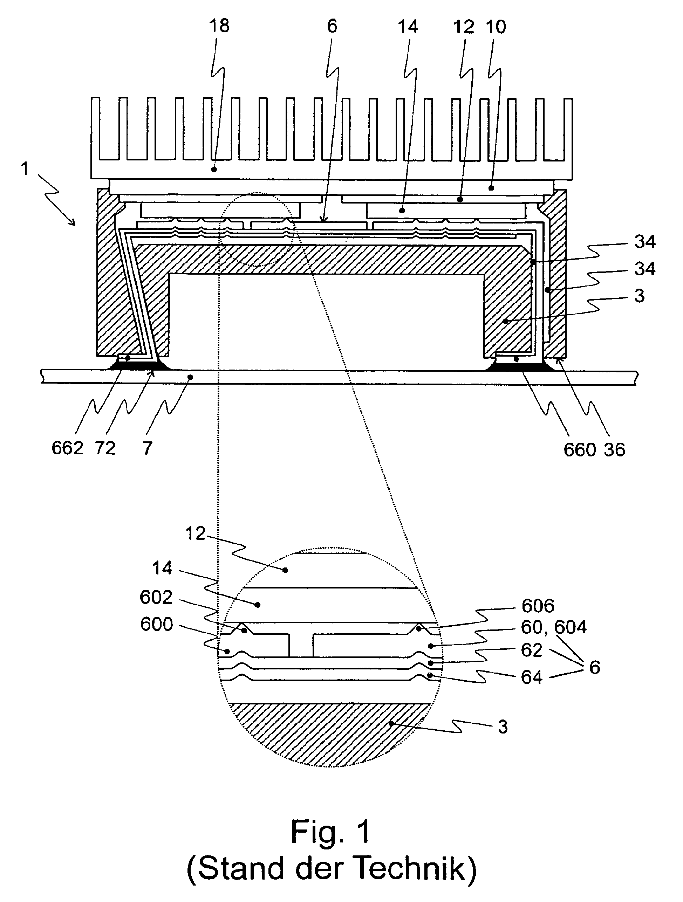

Fig. 1 zeigt eine Ausgestaltung einer Anordnung gemäß dem Stand der Technik mit einem Leistungshalbleitermodul (1), mit einer Verbindungseinrichtung (2) und einer externen Leiterplatte (7). Zwecks der Anschaulichkeit des Aufbaus ist weiterhin ein Kühlkörper (18) dargestellt.
Das Leistungshalbleitermodul besteht aus einem Gehäuse (3), welches ein elektrisch isolierendes Substrat (10) umschließt. Dieses wiederum weist einen Grundkörper, vorzugsweise eine Isolierkeramik wie Aluminiumoxid oder Aluminiumnitrit auf. Auf der dem Inneren des Leistungshalbleitermoduls zugewandten ersten Hauptfläche weist das Substrat (10) in sich strukturierte Leiterbahnen (12) auf. Auf den Leiterbahnen (12) des Substrats sind Leistungshalbleiterbauelemente (14) angeordnet und schaltungsgerecht mittels eines ersten Kontaktelements (6) verbunden, welches aus einer alternierenden Schichtfolge gebildet wird. Diese Schichtfolge, detailliert dargestellt im vergrößerten Ausschnitt zur Fig. 1, wird gebildet aus einer ersten (60) und einer zweiten (64) leitenden jeweils in sich strukturierten und somit Leiterbahnen ausbildenden Schicht und einer dazwischen angeordneten isolierenden Schicht (62). Hierbei kontaktiert die erste leitende Schicht (60) die Leistungshalbleiterbauelemente schaltgerecht (14) mittels Punktschweißverbindungen (602, 606). Weiterhin führt das Kontaktelement durch Durchführungen (34) im Gehäuse (3) an dessen Außenseite (36), wo es entsprechend ausgestaltete Kontaktabschnitte (660, 662) zur Last- und Steuerkontaktierung (72) mit einer externen Leiterplatte (7) ausbildet, wobei diese Kontaktierung mittels Lötverbindung ausgestaltet ist.

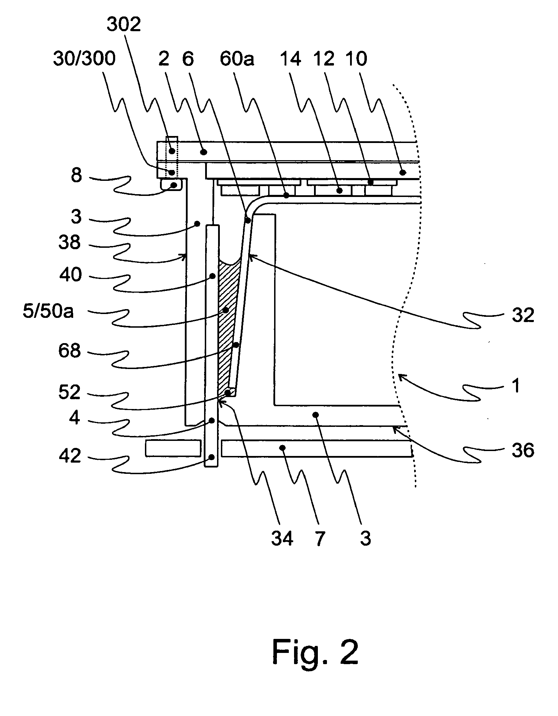

Fig. 2 zeigt einen Ausschnitt einer ersten Ausgestaltung eines erfindungsgemäßen Leistungshalbleitermoduls im Querschnitt, wobei baugleiche Elemente zu Fig. 1 nicht extra beschrieben werden.
Dargestellt ist die linke Seite des Leistungshalbleitermoduls (1) im Querschnitt mit dem ersten Kontaktelement (6), welches im Inneren eines rahmenartigen Gehäuses (3) angeordnet ist und die Leistungshalbleiterbauelemente (14) schaltungsgerecht kontaktiert (60a). Dem ersten Kontaktelement ist weiterhin ein einstückig aus dem Gehäuse ausgebildetes Widerlager (32) zugeordnet, welches einen ersten Kontaktabschnitt (68) des ersten Kontaktelements lagert und mit einer Seitenfläche (38a) des rahmenartigen Gehäuses einen Winkel von ca. 15° einschließt.

Weiterhin dargestellt ist ein zweites Kontaktelement (4), welches im Inneren des Leistungshalbleitermoduls angeordnet ist und dort einen zweiten Kontaktabschnitt (40) bildet. Weiterhin reicht das zweite Kontaktelement durch eine Durchführung (34) im Gehäuse (3) an dessen Außenseite (36), wo es einen dritten Kontaktabschnitt (42) bildet , welcher zur Kontaktierung mit einer externen Leiterplatte (7) dient, wobei hier die schaltungsgerechte Verbindung mit der externen Leiterplatte gemäß dem Stand der Technik bevorzugt mittels Durchstecklötmontage erfolgt, jedoch uneingeschränkt ebenso mittels Oberflächenlötmontage erfolgen kann.

Hierbei ist das zweite Kontaktelement durch teilweises Umspritzen mit dem Gehäusematerial fest mit dem Gehäuse verbunden. Durch die Anordnung von erstem (6) und zweitem (4) Kontaktelement bilden der erste Kontaktabschnitt (68) des ersten Kontaktelements (6) und der zweite Kontaktabschnitt (40) des zweiten Kontaktelements (4) einen annähernd keilförmiger Zwischenraum (5) im Inneren des Gehäuses (3) aus. Die Öffnung des Zwischenraum weist hierbei in Richtung des Substrates (10) und dient zur Aufnahme von Lot (50a), welches als elektrisch leitender Füllstoff (50) die Kontaktierung zwischen dem ersten und dem zweiten Kontaktelement herstellt. Die in entgegen gesetzter Richtung zum Substrat angeordnete geschlossene Endfläche des Zwischenraum weist ein kleinvolumiges Speicher (52) auf, welches den ersten Kontaktabschnitt (62) an seiner Endfläche umschließt und so die Zuverlässigkeit der Kontaktierung optimiert. Das Lot (50a) füllt den Zwischenraum zu 75 von 100 des Zwischenraum volumens aus.

Weiterhin dargestellt ist eine Schraubverbindung (8) zur Montage mit einem Kühlkörper (2). Hierbei weist das Gehäuse (3) des Leistungshalbleitermoduls einen ersten freigestellten, einstückig ausgebildeten Materialabschnitt (30) zur Aufnahme der Schraubverbindung (8) auf. Der freigestellte Materialabschnitt und der Kühlkörper weisen jeweils zueinander fluchtende Aussparungen (300, 302) auf, die zur Aufnahme der Schraubverbindung dienen.

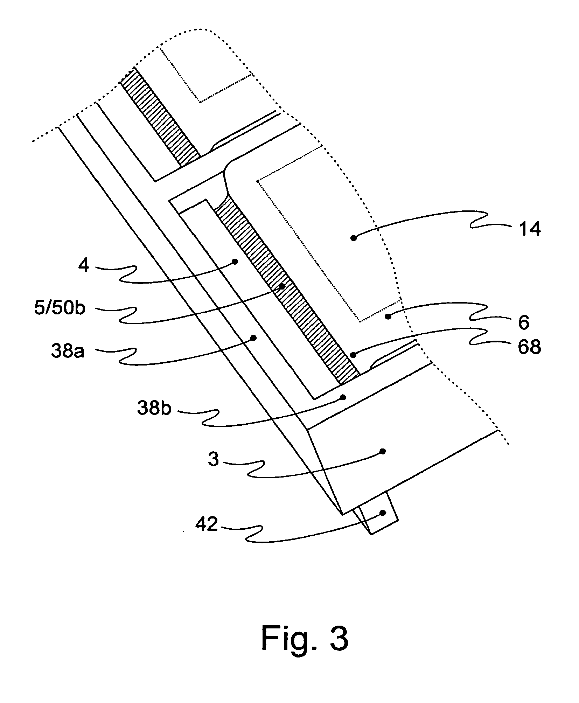

Fig. 3 zeigt einen nicht maßstäblichen Ausschnitt einer weiteren Ausgestaltung einer erfindungsgemäßen Anordnung in dreidimensionaler Linksdraufsicht ohne Kühlkörper und ohne Substrat, wobei wiederum baugleiche Elemente nicht extra beschrieben werden. Dargestellt sind die linke (38a) und die vordere (38b) Seitenwand des Gehäuses (3) sowie eine Zwischenwand des Gehäuses. Weiterhin dargestellt ist jeweils ein erstes Kontaktelement (6) mit jeweils einem Leistungshalbleiterbauelement (14) und einem ersten Kontaktabschnitt (68) und weiterhin jeweils ein zweites Kontaktelement (4), wodurch sich jeweils ein erfindungsgemäßer Zwischenraum (5) ausbildet. Hierbei ist der elektrisch leitende Füllstoff (50) ein Silberleitkleber (50b), welcher das Volumen des Zwischenraum (nicht darstellbar) zu 50 von 100 füllt. Die jeweils ersten Kontaktabschnitte (68) der jeweils ersten Kontaktelemente (6) nehmen zur linken Seitenwand (38a) des Gehäuses einen Winkel von 5° ein. Die jeweils zweiten Kontaktabschnitte der zweiten Kontaktelemente (4) sind mittels einer Klebeverbindung an ihrer jeweilige Berührungsfläche zur Seitenwand des Gehäuses (38a) sowie an der Durchführung aus dem Gehäuse an dessen Außenseite (nicht dargestellt) dauerhaft mit dem Gehäuse (3) verbunden. Aus der ihm zugeordneten Durchführung im Gehäuse bilden die zweiten Kontaktelemente (4) an der Außenseite des Gehäuses jeweils einen dritten Kontaktabschnitt (nur 42 dargestellt) aus.

## Patentansprüche

1. Leistungshalbleitermodul (1) mit
einem Substrat (10) mit ersten Leiterbahnen und auf diesen Leiterbahnen schaltungsgerecht angeordneten Leistungshalbleiterbauelementen,
einem Gehäuse (3),
mindestens einem ersten Kontaktelement (6) im Gehäuse-Inneren mit mindestens einem dem ersten Kontaktelement zugeordneten, einstückig aus dem Gehäuse ausgebildeten Widerlager (32), und
mindestens einem zweiten Kontaktelement (4), wobei
das erste Kontaktelement (6) aus einer alternierenden Schichtfolge mit mindestens einer ersten (60, 64) leitenden jeweils in sich strukturierten und somit Leiterbahnen ausbildenden Schicht und mindestens einer isolierenden Schicht (62) angeordnet ist,
die erste leitende Schicht (60, 64) die Leistungshalbleiterbauelemente schaltungsgerecht kontaktiert,
das erste Kontaktelement (6) mindestens einen ersten Kontaktabschnitt (68) zur Kontaktierung mit dem zweiten Kontaktelement (4) aufweist,
das Widerlager (32) den ersten Kontaktabschnitt (68) des ersten Kontaktelements (4) lagert,
das zweite Kontaktelement (4) mindestens einen im Gehäuse-Inneren angeordneten zweiten Kontaktabschnitt (40) zur Kontaktierung mit dem ersten Kontaktabschnitt (68) sowie mindestens einen durch eine Außenseite (36) des Gehäuses reichenden dritten Kontaktabschnitt (42) zur externen Kontaktierung aufweist, wobei
das Gehäuse eine dem dritten Kontaktabschnitt (42) des zweiten Kontaktelements (4) zugeordnete, an die Außenseite (36) des Gehäuses reichende Durchführung (34) aufweist, und
zwischen dem ersten Kontaktabschnitt (68) des ersten Kontaktelements (6) und dem zweiten Kontaktabschnitt (40) des zweiten Kontaktelements (4) ein Zwischenraum (5) ausgebildet ist, in welchem sich ein elektrisch leitender Füllstoff (50) befindet.

2. Anordnung nach Anspruch 1,
wobei das zweite Kontaktelement (4) mit dem Gehäuse (3) fest verbunden ist.

3. Anordnung nach Anspruch 2,
wobei die Verbindung des Gehäuses (3) mit dem zweiten Kontaktelement (4) durch teilweises Umspritzen des zweiten Kontaktelements mit dem Gehäusematerial oder mittels einer Klebeverbindung zwischen dem Gehäuse (3) und dem zweiten Kontaktelement (4) ausgestaltet ist.

4. Anordnung nach Anspruch 1,
wobei der leitende Füllstoff (50) als Lot (50a) oder als Leitkleber (50b) ausgestaltet ist.

5. Anordnung nach Anspruch 1,
wobei der Zwischenraum (5) trichterförmig oder keilförmig ausgestaltet ist.

6. Anordnung nach Anspruch 5,
wobei die Öffnung des trichterförmigen oder keilförmigen Zwischenraums (5) in Richtung des Substrats (10) ausgestaltet ist.

7. Anordnung nach Anspruch 1,
wobei der leitende Füllstoff (50) ein Füllvolumen von mindestens 50 von 100 des Volumens des taschenförmigen Zwischenraums (5) aufweist.

## Claims

1. A power semiconductor module (1) having
a substrate (10) with first conductor tracks and with power semiconductor components arranged on these conductor tracks to form a circuit,
a housing (3),
at least one first contact element (6) in the housing interior with at least one counter-support (32) assigned to the first contact element, integrally constructed out of the housing, and
at least one second contact element (4), wherein the first contact element (6) is arranged from an alternating layer sequence with at least one first (60, 64) conducting layer that is inherently structured and thus forming conductor tracks, and at least one insulating layer (62),
the first conducting layer (60, 64) contacts the power semiconductor components to form a circuit,
the first contact element (6) has at least one first contact section (68) for contacting to the second contact element (4),
the counter-support (32) supports the first contact section (68) of the first contact element (4),
the second contact element (4) has at least one second contact section (40) arranged inside the housing for contacting to the first contact section (68), and at least one third contact section (42) extending through an outer side (36) of the housing to provide external contacting, wherein
the housing has a through passage (34) assigned to the third contact section (42) of the second contact element (4), extending to the outside (36) of the housing, and
between the first contact section (68) of the first contact element (6) and the second contact section (40) of the second contact element (4) an intermediate space (5) is constructed, which contains an electrically conducting filler material (50).

2. The arrangement according to Claim 1, wherein the second contact element (4) is rigidly connected to the housing (3).

3. The arrangement according to Claim 2, wherein the connection of the housing (3) to the second contact element (4) is effected by partial overmoulding of the second contact element with the housing material or by means of an adhesive joint between the housing (3) and the second contact element (4).

4. The arrangement according to Claim 1, wherein the conducting filler material (50) is in the form of solder (50a) or a conducting adhesive (50b).

5. The arrangement according to Claim 1, wherein the intermediate space (5) is funnel-shaped or wedge-shaped.

6. The arrangement according to Claim 5, wherein the opening of the funnel-shaped or wedge-shaped intermediate space (5) is constructed in the direction of the substrate (10).

7. The arrangement according to Claim 1, wherein the conducting filler material (50) has a filling volume of at least 50 per cent of the volume of the pocket-shaped intermediate space (5).

## Revendications

1. Module à semi-conducteurs de puissance (1) comprenant un substrat (10) avec des premières pistes conductrices et des composants à semi-conducteurs de puissance disposés de façon conforme au circuit sur ces pistes conductrices,
un boîtier (3),
au moins un premier élément de contact (6) à l'intérieur du boîtier avec au moins un palier de butée (32) attribué au premier élément de contact et conçu d'une seule pièce à partir du boîtier, et
au moins un second élément de contact (4),
le premier élément de contact (6) étant agencé à partir d'une suite de couches alternante avec au moins une première couche (60, 64) conductrice, structurée à chaque fois sur elle-même et formant ainsi des pistes conductrices, et au moins une couche (62) isolante,
la première couche conductrice (60, 64) mettant en contact de façon conforme au circuit les composants à semi-conducteurs de puissance,
le premier élément de contact (6) présentant au moins une première partie de contact (68) pour la mise en contact avec le second élément de contact (4),
le palier de butée (32) supportant la première partie de contact (68) du premier élément de contact (4),
le second élément de contact (4) présentant au moins une seconde partie de contact (40) disposée à l'intérieur du boîtier pour la mise en contact avec la première partie de contact (68) et au moins une troisième partie de contact (42) passant à travers un côté extérieur (36) du boîtier pour la mise en contact externe,
le boîtier présentant un passage (34) attribué à la troisième partie de contact (42) du second élément de contact (4) et allant au côté extérieur (36) du boîtier, et
un espace intermédiaire (5), dans lequel se trouve une matière de charge (50) électroconductrice, se trouvant entre la première partie de contact (68) du premier élément de contact (6) et la seconde partie de contact (40) du second élément de contact (4).

2. Agencement selon la revendication 1,
le second élément de contact (4) étant relié fixement au boîtier (3).

3. Agencement selon la revendication 2,
la liaison du boîtier (3) avec le second élément de contact (4) étant conçue par surmoulage partiel du second élément de contact avec la matière de boîtier ou au moyen d'un assemblage collé entre le boîtier (3) et le second élément de contact (4).

4. Agencement selon la revendication 1,
la matière de charge (50) conductrice étant conçue comme agent de brasage (50a) ou comme colle conductrice (50b).

5. Agencement selon la revendication 1,
l'espace intermédiaire (5) étant conçu en forme d'entonnoir ou en forme de clavette.

6. Agencement selon la revendication 5,
l'ouverture de l'espace intermédiaire (5) en forme d'entonnoir ou en forme de clavette étant conçue en direction du substrat (10).

7. Agencement selon la revendication 1,
la matière de charge conductrice (50) présentant un volume de remplissage d'au moins 50 de 100 du volume de l'espace intermédiaire (5) en forme de poche.
